(19) Europäisches Patentamt
European Patent Office
Office européen des brevets

(11) **EP 4 700 411 A1**

(12) **EUROPEAN PATENT APPLICATION**
published in accordance with Art. 153(4) EPC

(43) Date of publication:
**25.02.2026 Bulletin 2026/09**

(21) Application number: **24845843.2**

(22) Date of filing: **01.07.2024**

(51) International Patent Classification (IPC):
**G01R 31/392** (2019.01)    **G01R 31/396** (2019.01)
**G01R 31/385** (2019.01)    **G01R 31/371** (2019.01)
**G01R 31/36** (2020.01)    **G01R 19/10** (2006.01)
**G01R 19/12** (2006.01)    **G01R 19/165** (2006.01)

(52) Cooperative Patent Classification (CPC):
**G01R 19/10; G01R 19/12; G01R 19/165;**
**G01R 31/36; G01R 31/371; G01R 31/385;**
**G01R 31/392; G01R 31/396;** Y02E 60/10

(86) International application number:
**PCT/KR2024/009174**

(87) International publication number:
**WO 2025/023539 (30.01.2025 Gazette 2025/05)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **21.07.2023 KR 20230095638**

(71) Applicant: **LG Energy Solution, Ltd.**
**Seoul 07335 (KR)**

(72) Inventor: **KIM, Young Jin**
**Daejeon 34122 (KR)**

(74) Representative: **Plasseraud IP**
**104 Rue de Richelieu**
**CS92104**
**75080 Paris Cedex 02 (FR)**

(54) **BATTERY DIAGNOSIS APPARATUS AND OPERATION METHOD THEREOF**

(57)    A battery diagnosis apparatus according to an embodiment disclosed herein includes a sensor configured to obtain voltage data of each of battery cells and a processor configured to calculate a voltage variance dV that is a difference between voltage values at two arbitrary points in time for each of the battery cells, based on the voltage data, calculate an accumulative variance based on the voltage variance, and diagnose whether the battery cells are abnormal, based on the accumulative variance.

**EP 4 700 411 A1**

FIG.1

## Description

**[Technical Field]**

CROSS-REFERENCE TO RELATED APPLICATION

This application claims priority to and the benefit of Korean Patent Application No. 10-2023-0095638 filed in the Korean Intellectual Property Office on July 21, 2023, the entire content of which is incorporated herein by reference.

TECHNICAL FIELD

Embodiments disclosed herein relate to a battery diagnosis apparatus and an operating method thereof.

**[Background Art]**

Recently, research and development of secondary batteries have been actively performed. Herein, the secondary batteries, which are chargeable/-dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

As industrial fields using batteries expand, battery management systems (BMSs) diagnosing safety of batteries are also developing. The BMS may diagnose performance of a battery by using various diagnosis algorithms, and perform appropriate control according to a state of the battery. The BMS may diagnose whether there is an abnormal battery cell. Herein, abnormality may include all causes that may be a cause for fire due to a damage or aging of the battery. In particular, the use of an electronic product having mounted thereon an abnormal battery due to lithium precipitation may be a cause for fire, such that it is necessary to early detect an abnormal battery cell.

**[Disclosure]**

**[Technical Problem]**

In a rest period after discharging, an abnormal battery cell may have a voltage behavior different from a normal battery cell. Hence, generally, by identifying a voltage difference obtained through a sensing signal for each of battery cells, the abnormal battery cell may be detected.

However, the sensing signal has a weak signal strength and an irregular signal period, and include various noises. Due to high uncertainty of the sensor signal, determination of whether the battery cell is an abnormal battery cell merely with the sensing signal may result in degrading the accuracy of detecting the abnormal battery cell.

Technical problems of the embodiments disclosed herein are not limited to the above-described technical problems, and other unmentioned technical problems would be clearly understood by one of ordinary skill in the art from the following description.

**[Technical Solution]**

A battery diagnosis apparatus according to an embodiment disclosed herein includes a sensor configured to obtain voltage data of each of battery cells and a processor configured to calculate a voltage variance dV that is a difference between voltage values at two arbitrary points in time for each of the battery cells, based on the voltage data, calculate an accumulative variance based on the voltage variance, and diagnose whether the battery cells are abnormal, based on the accumulative variance.

In an embodiment, the processor may be further configured to calculate a Z-score that standardizes the voltage variance based on an average value and a standard deviation of voltage variances of the battery cells and calculate the accumulative variance based on the Z-score.

In an embodiment, the average value and the standard deviation may be an average value and a standard deviation of voltage variances for each battery unit comprising at least some battery cells among the whole battery cells, and the processor may be further configured to calculate the Z-score for each battery unit, calculate the accumulative variance based on the Z-score, and diagnose whether the battery unit is abnormal, based on the accumulative variance.

In an embodiment, the two arbitrary points in time may be arbitrary two points in time in a rest period after discharging.

In an embodiment, the processor may be further configured to diagnose that a battery cell with the accumulative variance tending to increase is an abnormal battery cell.

In an embodiment, the battery diagnosis apparatus may further include a communication circuit configured to transmit a diagnosis result to a user terminal.

An operating method of a battery diagnosis apparatus according to an embodiment disclosed herein includes obtaining voltage data of each of battery cells, calculating a voltage variance dV that is a difference between voltage values at two arbitrary points in time for each of the battery cells, based on the voltage data, calculating an accumulative variance based on the voltage variance, and diagnosing whether the battery cells are abnormal, based on the accumulative variance.

In an embodiment, the operating method may further include calculating a Z-score that standardizes the voltage variance based on an average value and a standard deviation of voltage variances of the battery cells, in which the calculating of the accumulative variance includes calculating the accumulative variance based on the Z-score.

In an embodiment, the average value and the standard deviation may be an average value and a standard deviation of voltage variances for each battery unit including at least some battery cells among the whole battery cells, and the calculating of the Z-score may include calculating the Z-score for each battery unit, and the diagnosing may include diagnosing whether the battery unit is abnormal, based on the accumulative variance.

In an embodiment, the two arbitrary points in time may be arbitrary two points in time in a rest period after discharging.

In an embodiment, the diagnosing may include diagnosing that a battery cell with the accumulative variance tending to increase is an abnormal battery cell.

In an embodiment, the operating method may further include transmitting a diagnosis result to a user terminal.

**[Advantageous Effects]**

The battery diagnosis apparatus and the operating method thereof according to various embodiments disclosed herein may calculate an accumulative variance of a voltage variance of each battery cell, thereby detecting an abnormal battery cell based on a tendency of the accumulative variance occurring due to the abnormal battery cell.

The battery diagnosis apparatus and the operating method thereof according to various embodiments disclosed herein may convert a voltage variance for battery cells into a Z-score, thereby reducing an error that may occur between battery modules.

The effects of the battery diagnosis apparatus and the operating method thereof according to the disclosure of the present document are not limited to the effects mentioned above, and other effects not mentioned will be clearly understood by those of ordinary skill in the art according to the disclosure of the present document.

**[Description of Drawings]**

FIGS. 1 and 2 show a battery diagnosis apparatus according to an embodiment disclosed herein.
FIG. 3 is a block diagram of a battery diagnosis apparatus according to an embodiment disclosed herein.

FIG. 4 is a graph of voltage data of battery cells according to an embodiment disclosed herein.
FIG. 5 is a graph of an accumulative variance of battery cells included in different vehicles according to an embodiment disclosed herein.
FIG. 6 is a flowchart showing an operating method of a battery diagnosis apparatus to diagnose an abnormal battery cell, according to an embodiment disclosed herein.
FIG. 7 is a flowchart showing an operating method of a battery diagnosis apparatus to diagnose an abnormal battery unit, according to an embodiment disclosed herein.
With regard to the description of the drawings, similar reference numerals may be used to refer to similar or related components.

**[Mode for Invention]**

Hereinafter, embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the multiple entities may be separately disposed in different components. According to various embodiments disclosed herein, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

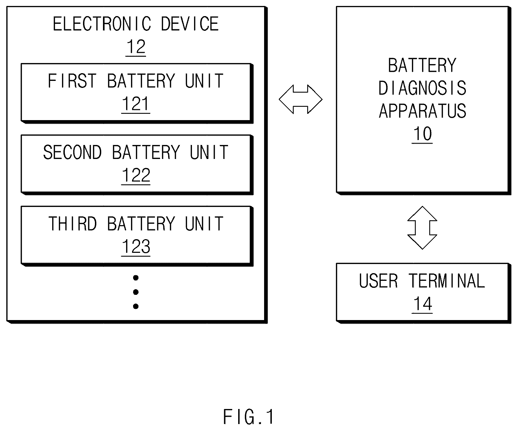

FIG. 1 is a block diagram of a battery diagnosis apparatus 10 according to an embodiment disclosed herein.

Referring to FIG. 1, the battery diagnosis apparatus 10 may be a battery management system (BMS) capable of diagnosing and controlling battery cells. In an embodiment, the battery diagnosis apparatus 10 may include a battery pack BMS, a slave BMS, or a combination thereof. The battery diagnosis apparatus 10 may be a BMS that controls and diagnoses battery cells by sensing a voltage, a current, and a temperature of the battery cells.

In another embodiment, the battery diagnosis apparatus 10 may be a server or a charger. The battery diagnosis apparatus 10 may be included in the server or the charger. Operations performed in the battery diagnosis apparatus 10 may be performed in the server or the charger.

The battery diagnosis apparatus 10 may obtain voltage data for battery units 121, 122, and 123 included in an electronic device 12. Herein, each of the battery units 121, 122, and 123 may be a battery cell, a battery module, a battery pack, or a battery rack. The voltage data may be a voltage value for the battery units 121, 122, and 123 in a designated time period. In an embodiment, the battery diagnosis apparatus 10 may obtain a voltage value for each of the battery units 121, 122, and 123 included in the electronic device 12, through a sensor. In an embodiment, the battery diagnosis apparatus 10 may obtain the voltage value for each of the battery units 121, 122, and 123 included in the electronic device 12, through a communication circuit. Herein, the sensor and the communication circuit may be included in the battery diagnosis apparatus 10, and will be described later.

The battery diagnosis apparatus 10 may calculate a voltage variance dV for each of the battery units 121, 122, and 123, based on voltage data. Herein, the voltage variance may be calculated based on a difference between voltage values at least two points in time, included in the voltage data for each of the battery units 121, 122, and 123.

The battery diagnosis apparatus 10 may calculate an accumulative variance obtained by accumulating a voltage variance of each of battery cells.

The battery diagnosis apparatus 10 may diagnose whether each of the battery units 121, 122, and 123 is abnormal, based on the accumulative variance.

The battery diagnosis apparatus 10 may transmit a diagnosis result to a user terminal. The battery diagnosis apparatus 10 may transmit the diagnosis result to the user terminal, through the communication circuit. Herein, the user terminal may be a mobile device or a personal computer (PC) through which the diagnosis result may be identified.

The battery diagnosis apparatus 10 may be wiredly and/or wirelessly connected to the electronic device 12 and the user terminal 14.

In an embodiment, connection between the battery diagnosis apparatus 10 and the electronic device 12 may be communication connection through a wired and/or wireless network. In an embodiment, the wired network may be based on a local area network (LAN) communication or a power-line communication. In an embodiment, the wireless network may be based on a short-range communication network (e.g., Bluetooth, Wireless Fidelity (WiFi), or Infrared Data Association (IrDA)) or a remote-range communication network (e.g., a cellular network, a 4th-Generation (4G) network, a 5th-Generation (5G) network).

In an embodiment, the connection between the battery diagnosis apparatus 10 and the electronic device 12 may be connection using a device-to-device communication scheme (e.g., a bus, a general-purpose input and output (GPIO), a serial peripheral interface (SPI), or a mobile industry processor interface (MIPI)).

In an embodiment, the connection between the battery diagnosis apparatus 10 and the user terminal 14 may be communication connection through a wired and/or wireless network.

In an embodiment, the electronic device 12 may be a mobile device (e.g., a mobile phone, a laptop computer, a smart phone, a smart pad), an electric vehicle (e.g., an electric vehicle (EV), a hybrid EV (HEV), a plug-in HEV (PHEV), a fuel cell EV (FCEV)), an energy storage system (ESS), or a battery swapping system (BSS).

In an embodiment, the electronic device 12 may include one or more battery units 121, 122, and 123. Herein, each of the battery units 121, 122, and 123 may be a battery cell, a battery module, a battery pack, or a battery rack.

In an embodiment, the user terminal 14 may be a mobile device (e.g., a mobile phone, a laptop computer, a smart phone, a smart pad), or a PC.

The following description will be made assuming that abnormality of a battery cell originates from lithium precipitation. However, this is merely an example, and abnormality of a battery cell may include abnormality caused by internal short-circuit, over-discharging, etc., that may be a cause for fire.

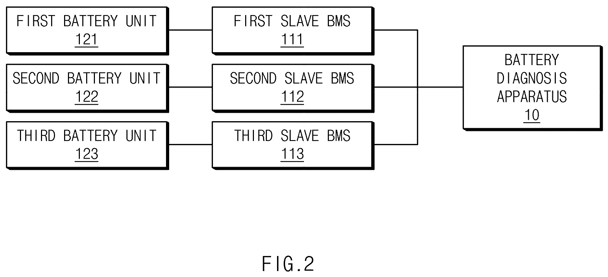

FIG. 2 shows the battery diagnosis apparatus 10 according to an embodiment disclosed herein.

Referring to FIG. 2, the battery diagnosis apparatus 10 may be a battery pack BMS that manages a plurality of slave BMSs 111, 112, and 113. The battery diagnosis apparatus 10 may obtain voltage data regarding the battery units 121, 122, and 123 from each of the slave BMSs 111, 112, and 113 and diagnose whether battery cells included in a battery pack are abnormal by using the obtained voltage data. Herein, the slave BMS may be a low-level system of the battery pack BMS and perform diagnosis and control on a battery unit. For example, the first slave BMS 111 may sense a voltage, a current, and a temperature of battery cells included in the first battery unit 121 and control and diagnose the battery cells included in the first battery unit 121. Each of the battery units 121, 122, and 123 may be a battery cell, a battery module, a battery pack, a battery rack, or a battery group. The battery group may indicate a set of battery cells that may be sensed by the slave BMS. For example, the first slave BMS 111 may diagnose and control the first battery unit 121 which may be referred to as a battery group.

The battery diagnosis apparatus 10 may obtain voltage data for each of the battery units 121, 122, and 123 from each of the plurality of slave BMSs 111, 112, and 113. Herein, the voltage data may be a voltage value for the battery units 121, 122, and 123 in a designated time period. For example, the battery diagnosis apparatus 10 may obtain a voltage value of the first battery unit 121 through the first slave BMS 111.

The battery diagnosis apparatus 10 may calculate a voltage variance of each of the battery units 121, 122, and 123, based on the voltage data.

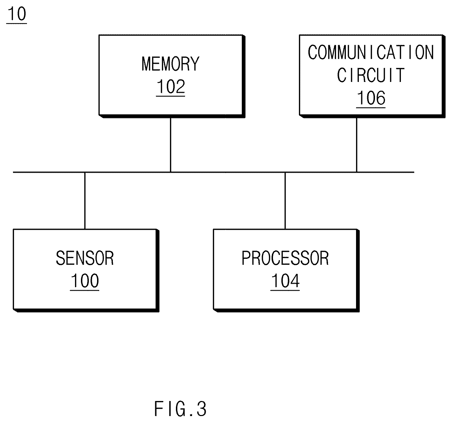

The battery diagnosis apparatus 10 may convert the voltage variance of each of the battery units 121, 122, and 123 into a Z-score. Herein, the Z-score may be a standardized value of each voltage variance based on an average value and a standard deviation of voltage variances of all the battery cells. In an embodiment, the battery diagnosis apparatus 10 may calculate a Z-score by using an average and a standard deviation of voltage variances per battery unit. For example, the first diagnosis apparatus 10 may calculate a Z-score for each of the battery cells included in the first battery unit 121, based on the average value and the standard deviation of the voltage variances for the battery cells included in the first battery unit 121. A method of calculating the Z-score will be described below with reference to FIG. 3.

The battery diagnosis apparatus 10 may calculate an accumulative variance that accumulates the Z-score for each of the battery units 121, 122, and 123.

The battery diagnosis apparatus 10 may diagnose whether each of the battery units 121, 122, and 123 is abnormal, based on the accumulative variance.

The battery diagnosis apparatus 10 may transmit a diagnosis result to the user terminal. The battery diagnosis apparatus 10 may transmit the diagnosis result to the user terminal, through the communication circuit. Herein, the user terminal may be a mobile device or a PC through which the diagnosis result may be identified.

FIG. 3 is a block diagram of the battery diagnosis apparatus 10 according to an embodiment disclosed herein.

Referring to FIG. 3, the battery diagnosis apparatus 10 may include a sensor 100, a memory 102, a processor 104, a communication circuit 106, or a combination thereof.

The sensor 100 may obtain values related to the states of the battery units 121, 122, and 123 of the electronic device 12. In an embodiment, the values related to the states may indicate one or more values of voltages, currents, resistances, SOC, states of health (SOH), or temperatures of the battery units 121, 122, and 123 or combinations thereof. The sensor 100 may obtain the voltage data of the battery units 121, 122, and 123. The sensor 100 may obtain the voltage data of the battery units 121, 122, and 123 for each designated cycle. Hereinbelow, the value related to the state may be referred to as a 'state value'.

In an embodiment, the sensor 100 may not be included in the battery diagnosis apparatus 10 when the operations performed in the battery diagnosis apparatus 10 are performed in a server or a charger. The battery diagnosis apparatus 10 may obtain the state values of the battery units 121, 122, and 123 through the communication circuit 106 when the sensor 100 is not included in the battery diagnosis apparatus 10.

The memory 102 may store data used by at least one component (e.g., the processor 104) of the battery diagnosis apparatus 10. For example, the data may include software (or an instruction related thereto), input data, or output data. In an embodiment, the instruction, when executed by the processor 104, may cause the battery diagnosis apparatus 10 to perform operations defined by the instruction. In an embodiment, the memory 102 may include a volatile and/or a nonvolatile memory. In an embodiment, the memory 102 may include one or more software.

The processor 104 may execute software (e.g., a battery diagnosis algorithm) to control at least one other component (e.g., a hardware or software component) of the battery diagnosis apparatus 10 connected to the processor 104, and may perform various data processing or computation.

The processor 104 may calculate the voltage variance dV for each of battery cells. The processor 104 may calculate a voltage variance of each battery cell, based on voltage data regarding each battery cell. The processor 104 may calculate a voltage variance based on voltage data in a rest period after discharging. The processor 104 may calculate a voltage variance based on voltage data in a designated time period of the rest period. Herein, the voltage variance may be calculated based on a difference between voltage values at least two points in time, included in the voltage data. The rest period after discharging may be a time period after an elapse of a specific time from turn-off of the vehicle. For example, the processor 104 may calculate a voltage variance of each battery cell based on a difference between a voltage value corresponding to 1200 seconds and a voltage value corresponding to 7200 seconds in the rest period after discharging, for each battery cell included in the first battery unit 101.

The processor 104 may calculate the voltage variance of each battery cell for every designated cycle. The processor 104 may calculate a voltage variance of each battery cell in the rest period after discharging for every designated cycle.

The processor 104 may calculate a Z-score based on the voltage variance. The processor 104 may convert the voltage variance into the Z-score for each battery cell. The processor 104 may calculate a Z-score obtained by standardizing the voltage variance of each battery cell, based on voltage variances for the battery cells. The processor 104 may convert the voltage variance of each battery cell into the Z-score based on the average value and the standard deviation of the voltage variances for the battery cells. Herein, the Z-score may be a standardized value of each voltage variance based on an average value and a standard deviation of voltage variances of all the battery cells. The Z-score may be expressed as Equation 1.

[Equation 1]

$$Z = \frac{x - \mu}{\sigma}$$

Herein, x indicates a voltage variance of each battery cell, $\mu$ indicates an average value of voltage variances, and $\sigma$ indicates a standard deviation of voltage variances.

In an embodiment, the processor 104 may calculate a Z-score per battery unit. The processor 104 may calculate the Z-score for each of the battery cells included in the same battery unit. The processor 104 may convert the voltage variance of each battery cell per battery unit into the Z-score. The processor 104 may calculate the Z-score per battery unit based on voltage variances per battery unit including at least some of the whole battery cells. The processor 104 may convert the voltage variance of each of the battery cells included in the same battery unit into the Z-score, based on the average value and the standard deviation of the voltage variances per battery unit. For example, the processor 104 may calculate voltage data for each of the battery cells included in the first battery unit 121, based on the average voltage and the standard deviation of the battery cells included in the first battery unit 121. Herein, the Z-score may be a value obtained by standardizing each of the voltage variances based on the average value and the standard deviation of the voltage variances of the battery units 121, 122, and 123. The processor 104 may reduce an error occurring due to a difference in SOC for each battery module by converting the voltage data into the Z-score to standardize the voltage data of the whole battery cells.

The processor 104 may calculate an accumulative variance obtained by accumulating a voltage variance of each battery cell. The processor 104 may calculate an accumulative variance obtained by accumulating a voltage variance of each battery cell according to a designated cycle.

In an embodiment, the processor 104 may calculate an accumulative variance obtained by accumulating a Z-score for each of the battery cells. The processor 104 may calculate the accumulative variance obtained by accumulating the Z-score based on the voltage variance obtained according to the designated cycle for each battery cell.

In an embodiment, the processor 104 may calculate the accumulative variance per battery unit. The processor 104 may calculate the accumulative variance based on the Z-score converted per battery unit. The processor 104 may calculate the accumulative variance based on the Z-score converted according to the designated cycle for each battery unit.

The processor 104 may diagnose whether a battery cell is abnormal, based on the accumulative variance. The processor 104 may diagnose whether a battery cell is abnormal, based on whether the accumulative variance tends to increase. The processor 104 may diagnose that the battery cell with the accumulative variance tending to increase is an abnormal battery cell. The processor 104 may diagnose that the battery cell with the accumulative variance exceeding a threshold value is an abnormal battery cell. Herein, the threshold value may be an average value or a median value of accumulative variances of the whole battery cells.

In an embodiment, the processor 104 may diagnose whether a battery unit is abnormal, based on the accumulative variance. The processor 104 may detect an abnormal battery unit, based on the accumulative variance. The processor 104 may diagnose whether the battery unit is abnormal, based on whether the accumulative variance tends to increase. The processor 104 may diagnose that the battery unit with the accumulative variance tending to increase is an abnormal battery unit. The processor 104 may diagnose that the battery unit with the accumulative variance exceeding a threshold value is an abnormal battery unit. Herein, the abnormal battery unit may be a battery module including one or more abnormal battery cells. The threshold value may be an average value or a median value of accumulative variances of the whole battery cells included in a battery unit.

The processor 104 described above may include a central processing unit, an application processor, a graphic processing unit, an NPU, an image signal processor, a sensor hub processor, or a communication processor.

The processor 104 may execute software to control at least one other component (e.g., a hardware or software component) of the battery diagnosis apparatus 10 connected to the processor 104 and may process or compute various data.

The communication circuit 106 may establish a wired communication channel and/or a wireless communication channel between the battery diagnosis apparatus 10 and the electronic device 12 and/or the user terminal 14, and transmit and receive data to and from the electronic device 12 and/or the user terminal 14 through the established communication channel.

In an embodiment, the communication circuit 106 may wiredly or wirelessly receive state values of the battery units 121, 122, and 123 from the electronic device 12 or the sensor 100, when the battery diagnosis apparatus 10 is included in the server or the charger.

In an embodiment, the communication circuit 106 may transmit a result of diagnosis performed by the processor 104 to the user terminal 14.

According to an embodiment, the battery diagnosis apparatus 10 shown in FIG. 3 may further include at least one component (e.g., a display, an input device, or an output device) in addition to components shown in FIG. 3.

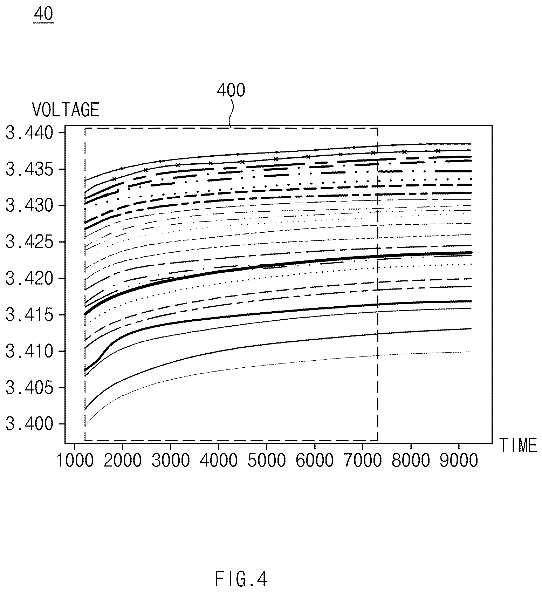

FIG. 4 is a graph 40 of voltage data of battery cells according to an embodiment disclosed herein.

Referring to FIG. 4, the graph 40 shows voltage values of battery cells in a designated time period 400. Herein, the designated time period 400 may be the entire rest period after discharging or a part thereof. Referring to the graph 40, the rest period after discharging may be a time period from 1200 seconds to 9000 seconds, and the designated time period 400 may be a time period between 1200 seconds and 7200 seconds.

The voltage data may be voltage values of the battery cells in a designated time period of the rest period after discharging. For example, the battery diagnosis apparatus 10 may calculate a voltage variance of each of the battery cells, based on a difference between a voltage value at 1200 seconds and a voltage value at 7200 seconds.

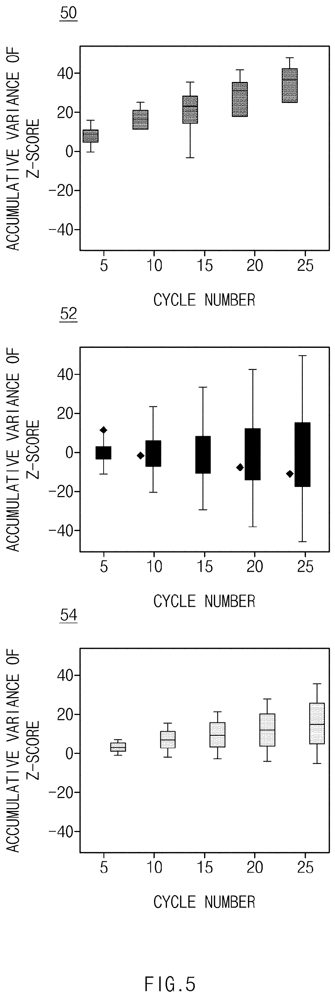

FIG. 5 are graphs 50, 52, and 54 of an accumulative variance according to an embodiment disclosed herein.

Referring to FIG. 5, a first graph 50 of an abnormal battery unit, a second graph 52 of a normal battery unit, and a third graph 54 of a battery unit based on other causes are shown. Herein, the other causes may include the other causes than a cause for fire. For example, the other causes may be poor quality occurring in a battery cell manufacturing process.

Referring to the first graph 50, as the cycles progress, the accumulative variance tends to increase. Herein, the tendency toward increase may include a result that the accumulative variance increases when compared to the initial cycle in spite of decrease in the accumulative variance in some cycles.

Referring to the second graph 52 and the third graph 54, as the cycles progress, the accumulative variance tends to decrease. Herein, the tendency toward decrease may include a result that the accumulative variance decreases when compared to the initial cycle in spite of increase in the accumulative variance in some cycles.

Referring to the graphs 50, 52, and 54, the battery diagnosis apparatus 10 may diagnose that the battery cell with the accumulative variance tending to increase according to a cycle is an abnormal battery cell.

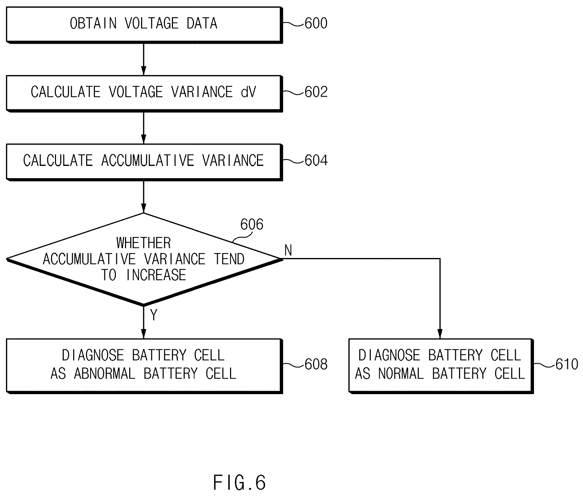

FIG. 6 is a flowchart showing an operating method of the battery diagnosis apparatus 10 to diagnose an abnormal battery cell, according to an embodiment disclosed herein.

Referring to FIG. 6, in operation 600, the sensor 100 may obtain the voltage data of the battery units 121, 122, and 123. The sensor 100 may obtain the voltage data of the battery units 121, 122, and 123 for each designated cycle. In an embodiment, the sensor 100 may not be included in the battery diagnosis apparatus 10 when the operations performed in the battery diagnosis apparatus 10 are performed in a server or a charger. The battery diagnosis apparatus 10 may obtain the state values of the battery units 121, 122, and 123 through the communication circuit 106 when the sensor 100 is not included in the battery diagnosis apparatus 10.

In operation 602, the processor 104 may calculate the voltage variance dV for each of battery cells. The processor 104 may calculate a voltage variance of each battery cell, based on voltage data regarding each battery cell. The processor 104 may calculate a voltage variance based on voltage data in a rest period after discharging. The processor 104 may calculate a voltage variance based on voltage data in a designated time period of the rest period.

The processor 104 may calculate the voltage variance of each battery cell for every designated cycle. The processor 104 may calculate a voltage variance of each battery cell in the rest period after discharging for every designated cycle.

In operation 604, the battery diagnosis apparatus 104 may calculate an accumulative variance obtained by accumulating a voltage variance of each of battery cells. The processor 104 may calculate an accumulative variance obtained by accumulating a voltage variance of each battery cell according to a designated cycle.

In operation 606, the processor 104 may diagnose whether a battery cell is abnormal, based on the accumulative variance. The processor 104 may diagnose whether a battery cell is abnormal, based on whether the accumulative variance tends to increase.

In operation 608, the processor 104 may diagnose that the battery cell with the accumulative variance tending to increase is an abnormal battery cell. The processor 104 may diagnose that the battery cell with the accumulative variance exceeding a threshold value is an abnormal battery cell.

In operation 610, the processor 104 may diagnose that the battery cell with the accumulative variance tending to decrease is a normal battery cell. The processor 104 may diagnose that the battery cell with the accumulative variance being less than or equal to the threshold value is a normal battery cell.

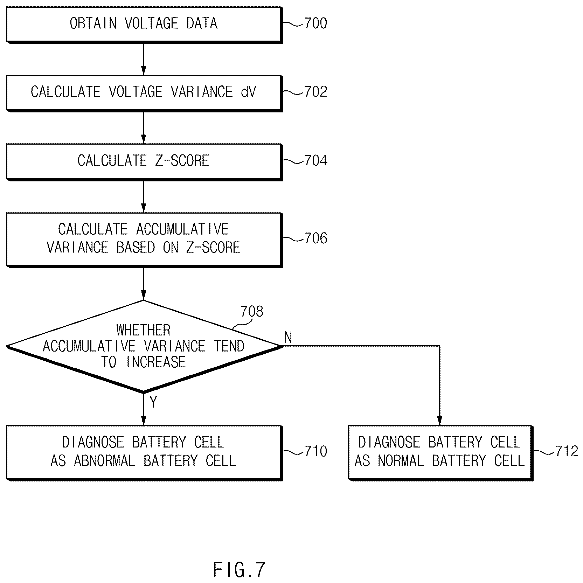

FIG. 7 is a flowchart showing an operating method of a battery diagnosis apparatus to diagnose an abnormal battery unit, according to an embodiment disclosed herein.

Referring to FIG. 7, in operation 700, the sensor 100 may obtain the voltage data of the battery units 121, 122, and 123. The sensor 100 may obtain the voltage data of the battery units 121, 122, and 123 for each designated cycle. In an embodiment, the sensor 100 may not be included in the battery diagnosis apparatus 10 when the operations performed in the battery diagnosis apparatus 10 are performed in a server or a charger. The battery diagnosis apparatus 10 may obtain the state values of the battery units 121, 122, and 123 through the communication circuit 106 when the sensor 100 is not included in the battery diagnosis apparatus 10.

In operation 702, the processor 104 may calculate the voltage variance dV for each of battery cells. The processor 104 may calculate a voltage variance of each battery cell, based on voltage data regarding each battery cell. The processor 104 may calculate a voltage variance based on voltage data in a rest period after discharging. The processor 104 may calculate a voltage variance based on voltage data in a designated time period of the rest period.

The processor 104 may calculate the voltage variance of each battery cell for every designated cycle. The processor 104 may calculate a voltage variance of each battery cell in the rest period after discharging for every designated cycle.

In operation 704, the processor 104 may calculate a Z-score based on the voltage variance. The processor 104 may convert the voltage variance into the Z-score for each battery cell.

In an embodiment, the processor 104 may convert the voltage variance of each battery cell per battery unit into the Z-score. The processor 104 may calculate the Z-score for each of the battery cells included in the same battery unit.

In operation 706, the battery diagnosis apparatus 104 may calculate an accumulative variance obtained by accumulating a voltage variance of each of battery cells. The processor 104 may calculate an accumulative variance obtained by accumulating a voltage variance of each battery cell according to a designated cycle.

In an embodiment, the processor 104 may calculate an accumulative variance obtained by accumulating a Z-score for each of the battery cells. The processor 104 may calculate the accumulative variance obtained by accumulating the Z-score based on the voltage variance obtained according to the designated cycle for each battery cell.

In an embodiment, the processor 104 may calculate the accumulative variance per battery unit. The processor 104 may calculate the accumulative variance based on the Z-score converted per battery unit. The processor 104 may calculate the accumulative variance based on the Z-score converted according to the designated cycle for each battery unit.

In operation 708, the processor 104 may diagnose whether a battery unit is abnormal, based on the accumulative variance. The processor 104 may detect an abnormal battery unit, based on the accumulative variance. The processor 104 may diagnose whether the battery unit is abnormal, based on whether the accumulative variance tends to increase.

In operation 710, the processor 104 may diagnose that the battery unit with the accumulative variance tending to increase is an abnormal battery unit. The processor 104 may diagnose that the battery unit with the accumulative variance exceeding a threshold value is an abnormal battery unit.

In operation 712, the processor 104 may diagnose that the battery unit with the accumulative variance tending to decrease is a normal battery unit. The processor 104 may diagnose that the battery unit with the accumulative variance being less than or equal to the threshold value is a normal battery unit.

The foregoing operations performed in the battery diagnosis apparatus 10 have been described assuming that they are performed in the BMS in the vehicle, but they may also be performed in an external server, a charger, etc.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

The above description is merely illustrative of the technical idea of the present disclosure, and various modifications and variations will be possible without departing from the essential characteristics of embodiments of the present disclosure by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present document.

**Claims**

1. A battery diagnosis apparatus comprising:

   a sensor configured to obtain voltage data of each of battery cells; and
   a processor configured to:

   calculate a voltage variance dV that is a difference between voltage values at two arbitrary points in time for each of the battery cells, based on the voltage data;
   calculate an accumulative variance based on the voltage variance; and
   diagnose whether the battery cells are abnormal, based on the accumulative variance.

2. The battery diagnosis apparatus of claim 1, wherein the processor is further configured to:

   calculate a Z-score that standardizes the voltage variance based on an average value and a standard deviation of voltage variances of the battery cells; and
   calculate the accumulative variance based on the Z-score.

3. The battery diagnosis apparatus of claim 2, wherein the average value and the standard deviation are an average value and a standard deviation of voltage variances for each battery unit comprising at least some battery cells among the whole battery cells, and
the processor is further configured to:

   calculate the Z-score for each battery unit;
   calculate the accumulative variance based on the Z-score; and
   diagnose whether the battery unit is abnormal, based on the accumulative variance.

4. The battery diagnosis apparatus of claim 1, wherein the two arbitrary points in time are arbitrary two points in time in a rest period after discharging.

5. The battery diagnosis apparatus of claim 1, wherein the processor is further configured to diagnose that a battery cell with the accumulative variance tending to increase is an abnormal battery cell.

6. The battery diagnosis apparatus of claim 1, further comprising a communication circuit configured to transmit a diagnosis result to a user terminal.

7. An operating method of a battery diagnosis apparatus, the operating method comprising:

   obtaining voltage data of each of battery cells; and
   calculating a voltage variance dV that is a difference between voltage values at two arbitrary points in time for each of the battery cells, based on the voltage data;
   calculating an accumulative variance based on the voltage variance; and
   diagnosing whether the battery cells are abnormal, based on the accumulative variance.

8. The operating method of claim 7, further comprising calculating a Z-score that standardizes the voltage variance based on an average value and a standard deviation of voltage variances of the battery cells, wherein the calculating of the accumulative variance comprises calculating the accumulative variance based on the Z-score.

9. The operating method of claim 8, wherein the average value and the standard deviation are an average value and a standard deviation of voltage variances for each battery unit comprising at least some battery cells among the whole battery cells, and

   the calculating of the Z-score comprises calculating the Z-score for each battery unit, and
   the diagnosing comprises diagnosing whether the battery unit is abnormal, based on the accumulative variance.

10. The operating method of claim 7, wherein the two arbitrary points in time are arbitrary two points in time in a rest period after discharging.

**11.** The operating method of claim 7, wherein the diagnosing comprises diagnosing that a battery cell with the accumulative variance tending to increase is an abnormal battery cell.

**12.** The operating method of claim 7, further comprising transmitting a diagnosis result to a user terminal.

ELECTRONIC DEVICE
12

FIRST BATTERY UNIT
121

SECOND BATTERY UNIT
122

THIRD BATTERY UNIT
123

BATTERY
DIAGNOSIS
APPARATUS
10

USER TERMINAL
14

FIG.1

| FIRST BATTERY UNIT<br>121 | FIRST SLAVE BMS<br>111 | BATTERY<br>DIAGNOSIS<br>APPARATUS<br>10 |
|---|---|---|
| SECOND BATTERY UNIT<br>122 | SECOND SLAVE BMS<br>112 | |
| THIRD BATTERY UNIT<br>123 | THIRD SLAVE BMS<br>113 | |

FIG.2

<u>10</u>

FIG.3

40

FIG.4

FIG.5

```
┌──────────────────────────────────┐
│        OBTAIN VOLTAGE DATA        │──600
└──────────────────────────────────┘
                 │
                 ▼
┌──────────────────────────────────┐
│    CALCULATE VOLTAGE VARIANCE dV  │──602
└──────────────────────────────────┘
                 │
                 ▼
┌──────────────────────────────────┐
│   CALCULATE ACCUMULATIVE VARIANCE │──604
└──────────────────────────────────┘
                 │
                 ▼
              606
        ◇ WHETHER
   ACCUMULATIVE VARIANCE TEND ──N──┐
        TO INCREASE ◇               │
                 │Y                 │
                 ▼                  ▼
┌──────────────────────┐   ┌──────────────────────┐
│  DIAGNOSE BATTERY CELL│   │  DIAGNOSE BATTERY CELL│
│  AS ABNORMAL BATTERY  │──608│  AS NORMAL BATTERY   │──610
│         CELL          │   │        CELL           │
└──────────────────────┘   └──────────────────────┘
```

FIG.6

```
┌─────────────────────────────────┐
│       OBTAIN VOLTAGE DATA        │──700
└─────────────────────────────────┘
                 │
                 ▼
┌─────────────────────────────────┐
│   CALCULATE VOLTAGE VARIANCE dV  │──702
└─────────────────────────────────┘
                 │
                 ▼
┌─────────────────────────────────┐
│        CALCULATE Z-SCORE         │──704
└─────────────────────────────────┘
                 │
                 ▼
┌─────────────────────────────────┐
│     CALCULATE ACCUMULATIVE       │──706
│    VARIANCE BASED ON Z-SCORE     │
└─────────────────────────────────┘
                 │
                 ▼
              708
         ╱          ╲
        ╱  WHETHER    ╲         N
       ╱ ACCUMULATIVE  ╲─────────────────────┐
       ╲ VARIANCE TEND ╱                     │
        ╲ TO INCREASE ╱                      │
         ╲          ╱                        │
              │ Y                            │
              ▼                              ▼
┌─────────────────────────┐      ┌─────────────────────────┐
│   DIAGNOSE BATTERY CELL │──710 │   DIAGNOSE BATTERY CELL │──712
│  AS ABNORMAL BATTERY CELL│     │  AS NORMAL BATTERY CELL │
└─────────────────────────┘      └─────────────────────────┘
```

FIG.7

## INTERNATIONAL SEARCH REPORT

| International application No. |
|---|
| **PCT/KR2024/009174** |

### A. CLASSIFICATION OF SUBJECT MATTER

**G01R 31/392**(2019.01)i; **G01R 31/396**(2019.01)i; **G01R 31/385**(2019.01)i; **G01R 31/371**(2019.01)i; **G01R 31/36**(2006.01)i; **G01R 19/10**(2006.01)i; **G01R 19/12**(2006.01)i; **G01R 19/165**(2006.01)i

According to International Patent Classification (IPC) or to both national classification and IPC

### B. FIELDS SEARCHED

Minimum documentation searched (classification system followed by classification symbols)

G01R 31/392(2019.01); B60L 58/10(2019.01); G01R 19/00(2006.01); G01R 31/3835(2019.01); G01R 31/396(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 셀(battery cell), 전압 변화량(voltage change amount), 누적 변화량 (cumulative change amount), 이상(abnormality), 진단(diagnosis)

### C. DOCUMENTS CONSIDERED TO BE RELEVANT

| Category* | Citation of document, with indication, where appropriate, of the relevant passages | Relevant to claim No. |
|---|---|---|
| X | KR 10-2022-0001364 A (LG ENERGY SOLUTION, LTD.) 05 January 2022 (2022-01-05) See paragraphs [0020] and [0059]; claims 1-2; and figure 1. | 1,4-7,10-12 |
| Y | | 2-3,8-9 |
| Y | KR 10-2023-0088014 A (LG ENERGY SOLUTION, LTD.) 19 June 2023 (2023-06-19) See paragraphs [0067] and [0085]-[0086]; claim 2; and figure 4. | 2-3,8-9 |
| A | KR 10-2022-0146255 A (LG ENERGY SOLUTION, LTD.) 01 November 2022 (2022-11-01) See paragraphs [0115]-[0131]; and figure 4. | 1-12 |
| A | KR 10-2021-0031336 A (LG CHEM, LTD.) 19 March 2021 (2021-03-19) See paragraphs [0080]-[0086]; and figure 5. | 1-12 |
| A | KR 10-2023-0018240 A (HYUNDAI MOTOR COMPANY et al.) 07 February 2023 (2023-02-07) See paragraphs [0072]-[0079]; and figure 3. | 1-12 |

☐ Further documents are listed in the continuation of Box C.　　☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **10 October 2024** | **11 October 2024** |

| Name and mailing address of the ISA/KR | Authorized officer |
|---|---|
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

| INTERNATIONAL SEARCH REPORT | International application No. |
|---|---|
| Information on patent family members | **PCT/KR2024/009174** |

| Patent document cited in search report | | | Publication date (day/month/year) | Patent family member(s) | | | Publication date (day/month/year) |
|---|---|---|---|---|---|---|---|
| KR | 10-2022-0001364 | A | 05 January 2022 | None | | | |
| KR | 10-2023-0088014 | A | 19 June 2023 | None | | | |
| KR | 10-2022-0146255 | A | 01 November 2022 | None | | | |
| KR | 10-2021-0031336 | A | 19 March 2021 | CN | 113811781 | A | 17 December 2021 |
| | | | | CN | 113811781 | B | 04 June 2024 |
| | | | | EP | 3958006 | A1 | 23 February 2022 |
| | | | | EP | 3958006 | B1 | 29 May 2024 |
| | | | | JP | 2022-532105 | A | 13 July 2022 |
| | | | | US | 11965936 | B2 | 23 April 2024 |
| | | | | US | 2022-0229122 | A1 | 21 July 2022 |
| | | | | WO | 2021-049753 | A1 | 18 March 2021 |
| KR | 10-2023-0018240 | A | 07 February 2023 | None | | | |

Form PCT/ISA/210 (patent family annex) (July 2022)

**REFERENCES CITED IN THE DESCRIPTION**

**Patent documents cited in the description**

- KR 1020230095638